(19) Europäisches Patentamt
European Patent Office
Office européen des brevets

(11) EP 3 742 871 A1

(12) **EUROPEAN PATENT APPLICATION**
published in accordance with Art. 153(4) EPC

(43) Date of publication:
**25.11.2020 Bulletin 2020/48**

(21) Application number: **19741873.4**

(22) Date of filing: **15.01.2019**

(51) Int Cl.:
***H05K 3/28*** *(2006.01)*
***B32B 27/00*** *(2006.01)*
***C09D 201/00*** *(2006.01)*
***H05K 1/02*** *(2006.01)*
***B32B 15/08*** *(2006.01)*
***C08J 5/12*** *(2006.01)*
***G03F 7/004*** *(2006.01)*

(86) International application number:
**PCT/JP2019/000833**

(87) International publication number:
**WO 2019/142753 (25.07.2019 Gazette 2019/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.01.2018 JP 2018005235**

(71) Applicant: **Taiyo Ink Mfg. Co., Ltd.**
**Hiki-gun, Saitama 355-0215 (JP)**

(72) Inventors:
- **SHIINA Touko**
**Hiki-gun, Saitama 355-0215 (JP)**
- **SATO Kazuya**
**Hiki-gun, Saitama 355-0215 (JP)**
- **ARAI Yasuaki**
**Hiki-gun, Saitama 355-0215 (JP)**
- **SHIMAMIYA Mariko**
**Hiki-gun, Saitama 355-0215 (JP)**

(74) Representative: **Hoffmann Eitle**
**Patent- und Rechtsanwälte PartmbB**
**Arabellastraße 30**
**81925 München (DE)**

# (54) CURABLE RESIN COMPOSITION, DRY FILM, CURED PRODUCT THEREOF, AND PRINTED CIRCUIT BOARD

(57) Provided is a curable resin composition in which cracks and peeling do not easily occur in a cured coating film while maintaining adhesiveness with a base material (insulating portion) or a circuit (conductive portion), even in the case of forming a cured coating film having an area where the coating film of the curable resin composition is overlapping on the circuit board. The curable resin composition according to the present invention is a curable resin composition comprising a curable resin, characterized in that, when a cured coating film α comprising a cured product of the curable resin composition is formed on the surface of the base material, the shear strength between the insulating portion and the cured coating film α is referred to as A (MPa); when a cured coating film α comprising a cured product of the curable resin composition is formed on the surface of the conductive portion of the base material, the shear strength between the conductive portion and the cured coating film α is referred to as B (MPa); and when a cured coating film α comprising a cured product of the curable resin composition is formed on the surface of a cured coating film β comprising the cured product of the curable resin composition, the shear strength between the cured coating film α and the cured coating film β is referred to as C (MPa); then A, B and C are all 1 MPa or more and 15 MPa or less; and A and B are 0.5 times or more and 5 times or less than C.

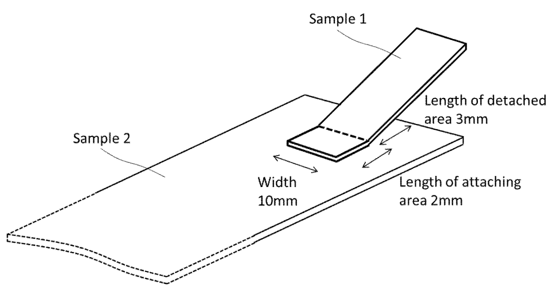


FIG.1

EP 3 742 871 A1

**Description**

BACKGROUND OF THE INVENTION

Field of the Invention

The present invention relates to a curable resin composition, and more particularly to a curable resin composition which is suitably used as an insulating curable coating film not only for a planar circuit board but also for a three dimensional circuit board, and the like.

Background Art

Along with downsizing/high functionalization of electronic equipment such as mobile phones and copying machines, there is a demand to include a circuit board in an inner face or an outer face of a housing in a compact manner. Among the circuit boards, the three dimensional circuit board, for example, does not form a conductive wiring on a housing or an electronic component in a planar state but in a three dimensional state, and is excellent in space efficiency, improvement of design, reduction of the number of parts by integration of parts and circuits, etc. Although such a three dimensional circuit board can be manufactured by various methods, in general, a three dimensional conductive wiring is formed by bending a flexible circuit board into a desired shape, or by attaching the flexible circuit board to the surface of a three dimensional component. However, the method using the flexible circuit board requires a lot of time and cost, and further, there is a limit to increasing the density. Therefore, is proposed a method for directly forming a circuit on a molded three dimensional board.

As a method for directly forming a circuit on a three dimensional board, there are proposed for example, a method for forming a circuit by physically masking a molded three dimensional electronic component and performing printing using a conductive paint (Patent Document 1), a method for forming a circuit by forming a metal thin film on the surface of a molded object by a vapor deposition method and removing the unnecessary metal thin film (Patent Document 2), a method for forming a circuit by attaching a metal foil to the molded object by a hot stamping method (Patent Document 3), and further, a method for forming a circuit by forming a metal nucleus by laser irradiation and the like after injection molding a resin containing a non-conductive metal complex, and applying plating to the area where the metal nucleus is formed (Patent Document 4), etc.

Even in the case of a three dimensional circuit board on which a circuit was directly formed on the above-described three dimensional board, an electronic component which is a passive component may be mounted on the conductive area such as the plated area. Even in this case, it is necessary to mount the electronic component on the substrate after placing a solder paste and the like at the connection site and carry out reflow process to connect the circuit and the electronic component as like in the case of a normal planar circuit board. However, in the three dimensional circuit board, since the board is not always perpendicular to the gravity direction, the solder paste which was liquefied at the time of the reflow process may flow down from the board, and solder may adhere to an unexpected area, which may cause a mounting failure. Therefore, it is necessary to mask in advance a curable resin composition such as a solder resist so that the solder paste does not adhere to the area other than the electrode on which the electronic component is mounted.

Prior art documents

Patent literature

Patent Document 1: Japanese Patent Application Laid-Open No. S63-234603
Patent Document 2: Japanese Patent Application Laid-Open No. 2008-53465
Patent Document 3: Japanese Patent Application Laid-Open No. 2001-15874
Patent Document 4: Japanese Patent Application Laid-Open No. 2004-534408

SUMMARY OF THE INVENTION

Problem to be solved by the invention

Masking is also conducted in the conventional planar circuit board, onto the board surface with a curable resin composition such as a solder resist. In a planar circuit board, a curable resin composition is applied to the entire board

surface and dried to form a coating film, or a dry film is adhered to the planar circuit board. On the other hand, in the case of a three dimensional circuit board, it is difficult to form a coating film on its entire surface at one time unless a special coating device (such as a 3D printing device) is used. Therefore, in order to form a coating film on the entire face of the three dimensional circuit board, it is necessary to apply the curable resin composition in multiple times, such as by forming the coating film on a part of the surface of the three dimensional circuit board and then forming the coating film again on the non-coated face.

When one intends to form a cured coating film on the entire surface of the three dimensional circuit board as described above, it will be necessary to repeat the operations of applying, drying, and curing the curable resin composition. Therefore, sometimes the curable resin composition may be applied again to a part of the area on which the cured coating film of the curable resin composition is already formed.

When the cured coating film is formed on the entire surface of the three dimensional circuit board as like above, sometimes cracks and peeling were seen in the cured coating film, which were not generated in the planar circuit board. When the present inventors investigated this phenomenon, it was found that cracks and peeling generated in the cured coating film formed on the surface of the three dimensional circuit board at the area where the coating film of the curable resin composition overlapped, that is, the area where the cured coating film was formed upon coating again the curable resin composition on the area where the cured coating film was once formed. In particular, cracking and peeling were remarkable at the time of reliability evaluation by heat cycle, and the like. That is, it has been found that when a cured coating film is formed on the surface of a circuit board provided with an insulating portion and a conductive portion, and if there is an area where the coating film of a curable resin composition is overlapped, there is a problem that the cured coating film cracks or peels off at that area.

Accordingly, the object of the present invention is to provide a curable resin composition in which cracks and peeling do not easily occur in a cured coating film while maintaining adhesiveness with the insulating portion and the conductive portion such as a circuit of a base material, even in the case of forming a cured coating film having an area where the coating film of the curable resin composition overlaps on the circuit board. Another object of the present invention is to provide a dry film, a cured product, and a printed wiring board formed using the curable resin composition.

Means for solving the problem

The present inventors have found that the cause of cracks or peeling of a cured coating film in the portion where a coating film of a curable resin composition overlaps is related to the shear strength of a cured product formed using the curable resin composition. The present inventors have obtained the knowledge that cracks and peeling are inhibited from generating in the portions where the curable resin composition overlaps by setting the shear strength between the cured product and the insulating portion of the base material, the shear strength between the cured product and the conductive portion of the base material, and the shear strength between the cured product and the curable resin composition obtained by separately curing a curable resin composition which was newly formed on a previously cured curable resin composition to a specific value range. The present invention is based on such knowledge.

[1] The curable resin composition according to the first embodiment of the present invention is a curable resin composition comprising a curable resin, characterized in that
when a cured coating film $\alpha$ comprising a cured product of the curable resin composition is formed on the surface of an insulating portion of a base material, the shear strength between the insulating portion and the cured coating film $\alpha$ is referred to as A (MPa);
when a cured coating film $\alpha$ comprising a cured product of the curable resin composition is formed on the surface of a conductive portion of the base material, the shear strength between the conductive portion and the cured coating film $\alpha$ is referred to as B (MPa); and
when a cured coating film $\alpha$ comprising a cured product of the curable resin composition is formed on the surface of a cured coating film $\beta$ comprising the cured product of the curable resin composition, the shear strength between the cured coating film $\alpha$ and the cured coating film $\beta$ is referred to as C (MPa); then
A, B and C are all 1 MPa or more and 15 MPa or less; and A and B are 0.5 times or more and 5 times or less than C.
[2] The curable resin composition according to the second embodiment of the present invention is the curable resin composition of [1], used for forming a cured coating film on the surface of a three dimensional structure.
[3] The curable resin composition according to the third embodiment of the present invention is the curable resin composition of [1] or [2], wherein the curable resin is a thermosetting resin.
[4] The curable resin composition according to the fourth embodiment of the present invention is the curable resin composition of any one of [1] to [3], used as an insulating material.
[5] A dry film according to the fifth embodiment of the present invention is a dry film comprising a resin layer formed by coating and drying the curable resin composition of any one of [1] to [4] onto a film.
[6] A cured product according to the sixth embodiment of the present invention is a cured product of any one of the

curable resin composition of [1] to [4] or the dry film of [5].

[7] A printed wiring board according to the seventh embodiment of the present invention is a printed wiring board having the cured product of [6].

Effect of the invention

According to the present invention, a curable resin composition can be realized in which cracks and peeling do not easily occur in the cured coating film while maintaining adhesion with a conductive portion such as an insulating portion or a circuit of a base material, even in the case of forming a cured coating film having an area where the coating film of the curable resin composition overlaps on a circuit board. According to another aspect of the present invention, there can be provided a dry film, a cured product, and a printed wiring board formed using the curable resin composition.

BRIEF DESCRIPTION OF THE DRAWINGS

FIG. 1 is a schematic diagram showing a sample used for measuring the shear strength.

DETAILED DESCRIPTION OF THE INVENTION

MODE FOR CARRYING OUT THE INVENTION

< Curable Resin Composition >

The curable resin composition according to the present invention comprises a curable resin and is characterized in that

when a cured coating film $\alpha$ comprising a cured product of the curable resin composition is formed on the surface of an insulating portion of a base material, the shear strength between the insulating portion and the cured coating film $\alpha$ is referred to as A (MPa);

when a cured coating film $\alpha$ comprising a cured product of the curable resin composition is formed on the surface of a conductive portion of the base material, the shear strength between the conductive portion and the cured coating film $\alpha$ is referred to as B (MPa); and

when a cured coating film $\alpha$ comprising a cured product of the curable resin composition is formed on the surface of a cured coating film $\beta$ comprising the cured product of the curable resin composition, the shear strength between the cured coating film $\alpha$ and the cured coating film $\beta$ is referred to as C (MPa); then

A, B and C are all 1 MPa or more and 15 MPa or less; and A and B are 0.5 times or more and 5 times or less than C.

In the present invention, the shear strength is measured by applying tensile shear load parallel to the bonding surface of the test substrate using a tensile testing machine and is calculated by the following formula. Note that, the shear strength in the present invention is defined as the value measured at room temperature.

$$\text{Shear strength (MPa)} = \text{Shear load (N)} / \text{area (mm}^2\text{)}$$

The cured product in the present invention is one as to be described later.

The method for forming a cured coating film $\alpha$ comprising a cured product of the curable resin composition of the present invention on the surface of the insulating portion of the base material is, for example, formed under the following conditions. First, a dry coating film of a curable resin composition is prepared. Onto one face of a copper clad laminate ESPANEX MB (manufactured by Nippon Steel Chemical & Materials Co., Ltd.) in which a copper film is laminated on both sides of a polyimide base material, having a length of 7.5 cm, a width of 2 cm and a thickness of 25 $\mu$m which has been buffed and subsequently washed with water and dried, is coated with a curable resin composition by screen printing and dried. The purpose of the drying conditions here is to evaporate the solvent by heating to the extent that stickiness disappears after drying, and for example, drying is carried out at 80 °C for 10 minutes. The copper clad laminate with a surface onto which a dry coating film of a curable resin composition is formed is cut into strips of 5 cm in length and 1 cm in width, and this is used as Sample 1.

Next, a FR-4 etched-out material having a length of 7.5 cm, a width of 2 cm and a thickness of 1.6 mm which has been buffed and subsequently washed with water and dried, is prepared as Sample 2. A dry coating film face of the curable resin composition of the above-described Sample 1 is attached to one face of Sample 2. At this time, they are attached together so that the attaching area is 5 mm in length and 10 mm in width. Samples 1 and 2 are attached together and subsequently temporarily fixed for 1 minute under vacuum using a vacuum laminator set to 80 °C, and the dry coating film of Sample 1 is fully cured by heating and curing to form a cured coating film $\alpha$ on the surface of the insulating

portion of the base material. The curing process here is carried out, for example, at 60 to 220 °C for 20 to 120 minutes using a hot air circulation drying furnace. Subsequently, only a portion in 3 mm in length is detached from the end portion of the attached face between Samples 1 and 2, and as shown in FIG. 1, a sample in which the attaching area is 2 mm in length and 10 mm in width is used as the sample for measuring shear strength A.

The method for forming a cured coating film α comprising a cured product of the curable resin composition of the present invention on the surface of the conductive portion of the base material is, for example, formed under the following conditions. First, a dry coating film of a curable resin composition is prepared. Onto one face of a copper clad laminate ESPANEX MB (manufactured by Nippon Steel Chemical & Materials Co., Ltd.) in which a copper film is laminated on both sides of a polyimide base material, having a length of 7.5 cm, a width of 2 cm and a thickness of 25 μm which has been buffed and subsequently washed with water and dried, is coated a curable resin composition by screen printing and dried. The purpose of the drying conditions here is to evaporate the solvent by heating to the extent that stickiness disappears after drying, and for example, drying is carried out at 80 °C for 10 minutes. The copper clad laminate with a surface onto which a dry coating film of a curable resin composition is formed is cut into strips of 5 cm in length and 1 cm in width, and this is used as Sample 1.

Next, a FR-4 copper clad laminate MCL-E-67 (manufactured by Hitachi Chemical Co., Ltd.) having a length of 7.5 cm, a width of 2 cm, and a thickness of 1.6 mm, which has been buffed and subsequently washed with water and dried, is prepared as Sample 2'. To one face of Sample 2', a dry coating film of the curable resin composition of the above-described Sample 1 is attached. At this time, they are attached together so that the attaching area is 5 mm in length and 10 mm in width. Samples 1 and 2' are attached together and subsequently temporarily fixed for 1 minute under vacuum using a vacuum laminator set to 80 °C, and the dry coating film of Sample 1 is fully cured by heating and curing to form a cured coating film α on the surface of the insulating portion of the base material. The curing process here is carried out, for example, at 60 to 220 °C for 20 to 120 minutes using a hot air circulation drying furnace. Subsequently, only a portion in 3 mm in length is detached from the end portion of the attached face between Samples 1 and 2', and as shown in FIG. 1, a sample in which the attaching area is 2 mm in length and 10 mm in width is used as the sample for measuring shear strength B.

A method for forming a cured coating film α comprising a cured product of the curable resin composition of the present invention on the surface of a cured coating film β comprising a cured product of the curable resin composition is, for example, formed under the following conditions. First, a dry coating film of a curable resin composition is prepared. Onto one face of a copper clad laminate ESPANEX MB (manufactured by Nippon Steel Chemical & Materials Co., Ltd.) in which a copper film is laminated on both sides of a polyimide base material, having a length of 7.5 cm, a width of 2 cm and a thickness of 25 μm, which has been buffed and subsequently washed with water and dried, is applied a curable resin composition by screen printing and dried. The purpose of the drying conditions here is to evaporate the solvent by heating to the extent that stickiness disappears after drying, and for example, drying is carried out at 80 °C for 10 minutes. The copper clad laminate with a surface onto which a dry coating film of a curable resin composition is formed is cut into strips of 5 cm in length and 1 cm in width, and this is used as Sample 1.

Next, to one face of a FR-4 etched-out material having a length of 7.5 cm, a width of 2 cm, and a thickness of 1.6 mm, which has been buffed and subsequently washed with water and dried, is applied the curable resin composition by screen printing, and the cured coating film β which is finally cured by heat curing is prepared as Sample 2". The curing process here is carried out, for example, at 60 to 150 °C for 5 to 60 minutes using a hot air circulation drying furnace. To the surface of the cured coating film β of Sample 2", a dry coating film of the curable resin composition of the above-described Sample 1 is attached. At this time, they are attached together so that the attaching area is 5 mm in length and 10 mm in width. Samples 1 and 2" are attached together and subsequently temporarily fixed for 1 minute under vacuum using a vacuum laminator set to 80 °C, and the dry coating film of Sample 1 is fully cured by heating and curing to form a cured coating film α on the surface of the cured coating film β. The curing process here is carried out, for example, at 60 to 220 °C for 20 to 120 minutes using a hot air circulation drying furnace. Subsequently, only a portion in 3 mm in length is detached from the end portion of the attached face between Samples 1 and 2", and as shown in FIG. 1, a sample in which the attaching area is 2 mm in length and 10 mm in width is used as the sample for measuring shear strength C.

The shear strength is defined as the value obtained by dividing the shear load (N) measured at room temperature using a tensile testing machine at a tensile speed of 10 mm / min. by the attached area (2 mm × 10 mm). As the tensile testing machine, for example, an autograph AG-X manufactured by Shimadzu Corporation can be used.

The shear strengths A to C measured as described above must be 1 MPa or more and 15 MPa or less, respectively. In the case where each of the shear strengths A to C has a shear strength of 1 MPa or more, the adhesion to the coated face is excellent, and the cured coating film becomes uneasily peeled off. On the other hand, in the case where each of the shear strengths A to C is 15 MPa or less, the adhesion strength is too excessive so that stress is not applied too much, and as a result, cracks are less likely to be generated.

Shear strengths A to C measured as described above require that A and B are 0.5 times or more and 5 times or less than C. In the case where the shear strength is in the above range and even in a state of being attached to 3

different bonding faces, a large load stress is less likely to be applied to each of them, and as a result, a high adhesive strength can be maintained in a high dimension.

The composition of the above-described curable resin composition can be appropriately adjusted (for example, the type, amount, etc., of the contained component) so that shear strengths A to C fall within the above ranges. For example, when an epoxy resin is used, known as to contract during curing, as a curable resin to be described later, the value of shear strength C can also be controlled by the degree of curing shrinkage. The value of shear strength C can also be controlled by the epoxy equivalent and the like. Hereinafter, each component constituting the curable resin composition will be described.

[Curable Resin]

The curable resin composition according to the present invention comprises a curable resin as an essential component. The curable resin used in the present invention is a thermosetting resin or a photocurable resin, and may be a mixture thereof, and preferably is a thermosetting resin. Examples of the thermosetting resin include an epoxy compound, an oxetane compound, a blocked isocyanate compound, a melamine resin, and a silicone resin. Particularly, in the present invention, at least any one of an epoxy compound, an oxetane compound, and a blocked isocyanate compound can be suitably used.

As the epoxy compound, a commonly used compound having one or more epoxy groups can be used, and among them, a compound having two or more epoxy groups is preferable. Examples include monoepoxy compounds such as butyl glycidyl ether, phenyl glycidyl ether, and glycidyl(meth)acrylate, and compounds having two or more epoxy groups in one molecule such as bisphenol A type epoxy resin, bisphenol S type epoxy resin, bisphenol F type epoxy resin, phenol novolak type epoxy resin, cresol novolak type epoxy resin, alicyclic epoxy resin, trimethylolpropane polyglycidyl ether, phenyl-1,3-diglycidyl ether, biphenyl-4,4'-diglycidyl ether, 1,6-hexanediol diglycidyl ether, diglycidyl ether of ethylene glycol or propylene glycol, sorbitol polyglycidyl ether, tris(2,3-epoxypropyl)isocyanurate, triglycidyl tris(2-hydroxyethyl)isocyanurate, and the like. These may be used alone or two or more may be used in combination, depending on the required characteristics.

Specific examples of the compound having two or more epoxy groups include jER828, jER834, jER1001, and jER1004, manufactured by Mitsubishi Chemical Corporation; EPICLON 840, EPICLON 850, EPICLON 1050, and EPICLON 2055 manufactured by DIC Corporation; Epotohto YD-011, YD-013, YD-127, and YD-128, manufactured by Nippon Steel Chemical & Materials Co., Ltd.; D.E.R. 317, D.E.R. 331, D.E.R. 661, and D.E.R. 664, manufactured by Dow Chemical Company Japan K.K.; SUMI-EPOXY ESA-011, ESA-014, ELA-115, and ELA-128, manufactured by Sumitomo Chemical Co., Ltd.; bisphenol A type epoxy resins such as A.E.R. 330, A.E.R. 331, A.E.R. 661, A.E.R. 664, etc. (all product names) manufactured by Asahi Kasei E-Materials Corporation; jERYL903 from Mitsubishi Chemical Corporation; EPICLON 152 and EPICLON 165 manufactured by DIC Corporation; Epotohto YDB-400 and YDB-500 manufactured by Nippon Steel Chemical & Materials Co., Ltd.; D.E.R. 542 manufactured by Dow Chemical Company Japan K.K.; SUMI-EPOXY ESB-400 and ESB-700 manufactured by Sumitomo Chemical Co., Ltd.; brominated epoxy resins such as A.E.R. 711 and A.E.R. 714, etc. (all product names) manufactured by Asahi Kasei E-Materials Corporation; jER152 and jER154 manufactured by Mitsubishi Chemical Corporation; D.E.N. 431 and D.E.N. 438 manufactured by Dow Chemical Company Japan K.K.; EPICLON N-730, EPICLON N-770, and EPICLON N-865, manufactured by DIC Corporation; Epotohto YDCN-701 and YDCN-704 manufactured by Nippon Steel Chemical & Materials Co., Ltd.; EPPN-201, EOCN-1025, EOCN-1020, EOCN-104S, RE-306, and NC-3000, manufactured by Nippon Kayaku Co., Ltd.; SUMI-EPOXY ESCN-195X and ESCN- 220 manufactured by Sumitomo Chemical Co., Ltd.; A.E.R. ECN-235 and ECN-299, manufactured by Asahi Kasei E-Materials Corporation; YDCN-700-2, YDCN-700-3, YDCN-700-5, YDCN-700-7, YDCN-700-10, YDCN-704, and YDCN-704A, manufactured by Nippon Steel Chemical & Materials Co., Ltd.; novolak type epoxy resins such as EPICLON N-680, N-690, and N-695 (all product names) manufactured by DIC Corporation; EPICLON830 manufactured by DIC Corporation; jER807 manufactured by Mitsubishi Chemical Corporation; bisphenol F type epoxy resins such as Epotohto YDF-170, YDF-175, and YDF-2004 (all product names) manufactured by Nippon Steel Chemical & Materials Co., Ltd.; hydrogenated bisphenol A type epoxy resins such as Epotohto ST-2004, ST-2007, ST-3000 (all product names) manufactured by Nippon Steel Chemical & Materials Co., Ltd.; jER604 manufactured by Mitsubishi Chemical Corporation; Epotohto YH-434 manufactured by Nippon Steel Chemical & Materials Co., Ltd.; glycidyl amine-type epoxy resins such as SUMI-EPOXY ELM-120, etc., (all product names) manufactured by manufactured by Sumitomo Chemical Co., Ltd.; hydantoin-type epoxy resins; alicyclic epoxy resins such as Celloxide 2021, etc., (all product names) manufactured by DAICEL CORPORATION; YL-933 manufactured by Mitsubishi Chemical Corporation; trihydroxyphenyl methane-type epoxy resins such as T.E.N., EPPN-501, and EPPN-502 (all product names) manufactured by manufactured by Dow Chemical Company Japan K.K.; xylenol-type or biphenol-type epoxy resins such as YL-6056, YX-4000, and YL-6121 (all product names) manufactured by manufactured by Mitsubishi Chemical Corporation, or mixtures thereof; EBPS-200 manufactured by Nippon Kayaku Co., Ltd.; EPX-30 manufactured by ADEKA CORPORATION; bisphenol S-type epoxy resins such as EXA-1514 (product name) manufactured by DIC Corporation; bisphenol A novolac-type

epoxy resins such as jER157S (product name) manufactured by manufactured by Mitsubishi Chemical Corporation; tetraphenylol ethane-type epoxy resins such as jERYL931, etc., (all product names) manufactured by manufactured by Mitsubishi Chemical Corporation; heterocyclic epoxy resins such as TEPIC, etc., (all product names) manufactured by manufactured by Nissan Chemical Industries, Corporation; diglycidyl phthalate resins such as BLEMMER DGT, etc., (product name) manufactured by NOF CORPORATION; tetraglycidyl xylenoyl ethane resins such as ZX-1063, etc., (product name) manufactured by Nippon Steel Chemical & Materials Co., Ltd.; naphthalene group-containing epoxy resins such as HP-4032, EXA-4750, and EXA-4700 (product name) manufactured by DIC Corporation; epoxy resins having a dicyclopentadiene skeleton such as HP-7200 and HP-7200H (product name) manufactured by DIC Corporation; glycidyl methacrylate copolymer-based resins such as CP-50S and CP-50M manufactured by NOF CORPORATION; and also copolymer epoxy resin of cyclohexyl maleimide and glycidyl methacrylate; and CTBN-modified epoxy resins; without limitation. These epoxy resins may be used alone or two or more kinds may be used in combination.

As for the oxetane compound, suitably used is the oxetane compound containing an oxetane ring represented by the following general formula (I):

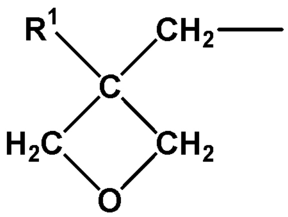

(I)

wherein, $R^1$ represents a hydrogen atom or an alkyl group having 1 to 6 carbons. Specific examples of such oxetane compound include 3-ethyl-3-hydroxymethyloxetane (product name: OXT-101, manufactured by TOAGOSEI CO., LTD.), 3-ethyl-3-(phenoxymethyl)oxetane (product name: OXT-211, manufactured by TOAGOSEI CO., LTD.), 3-ethyl-3-(2-ethylhexyloxymethyl)oxetane (product name: OXT-212, manufactured by TOAGOSEI CO., LTD.), 1,4-bis{[(3-ethyl-3-oxetanyl)methoxy]methyl}benzene (product name: OXT-121, manufactured by TOAGOSEI CO., LTD.), and bis(3-ethyl-3-oxetanylmetyl)ether (product name: OXT-221, manufactured by TOAGOSEI CO., LTD.). Further, mention can be made to an oxetane compound of a phenol novolak type. These oxetane compounds may be used in combination with the above epoxy compounds or may be used alone.

As the blocked isocyanate compound, use is made to an addition reaction product of an isocyanate compound and an isocyanate blocking agent. Examples of the isocyanate compound used for synthesizing the blocked isocyanate compound include an aromatic polyisocyanate, an aliphatic polyisocyanate, and an alicyclic polyisocyanate. Mention can also be made to adducts, burettes, and isocyanurates of the previously mentioned isocyanate compounds.

Examples of the isocyanate blocking agent include a phenolic blocking agent, a lactam blocking agent, an active methylene blocking agent, an alcoholic blocking agent, an oxime blocking agent, a mercaptan blocking agent, an acid amide blocking agent, an imide blocking agent, an amine blocking agent, an imidazole blocking agent, an imine blocking agent, and the like.

The blocked isocyanate compound may be a commercially available compound, for example, Sumidur BL-3175, BL-4165, BL-1100, BL-1265, Desmodur TPLS-2957, TPLS-2062, TPLS-2078, TPLS-2117, Desmotherm 2170, Desmotherm 2265 (all manufactured by Sumika Covestro Urethane Co., Ltd., product name), Coronate 2512, Coronate 2513, Coronate 2520 (all manufactured by Tosoh Corporation, product name), B-830, B-815, B-846, B-870, B-874, B-882 (all manufactured by Mitsui Chemicals, Inc., product name), MF-K60B, SBB-70P, SBN-70D, MF-B60B, TPA-B80E, 17B-60P, SBN-70D, and E402-B80T (all manufactured by Asahi Kasei Corporation, product name), and the like.Note that, Sumidur BL-3175 and BL-4265 are obtained using methyl ethyl oxime as a blocking agent.

In the present invention, a photocurable resin may be included as the curable resin. The photocurable resin may be a resin which is cured by irradiation with active energy rays and exhibits electrical insulating properties, and in the present invention, a compound having one or more ethylenically unsaturated bonds in a molecule is preferably used.

As the compound having an ethylenically unsaturated bond, use is made to commonly used photopolymerizable oligomers, photopolymerizable vinyl monomers, and the like. Examples of the photopolymerizable oligomer include an unsaturated polyester oligomer and (meth)acrylate oligomer, and the like. Examples of the (meth)acrylate oligomer include epoxy (meth)acrylates such as phenol novolak epoxy (meth)acrylate, cresol novolak epoxy (meth)acrylate, bisphenol epoxy (meth)acrylate, urethane (meth)acrylate, epoxy urethane (meth)acrylate, polyester (meth)acrylate, polyether (meth)acrylate, polybutadiene modified (meth)acrylate, and the like. In the present specification, the term "(meth) acrylate" is a term for collectively referring to acrylate, methacrylate and mixtures thereof, and the same applies to other similar expressions.

As for the photopolymerizable vinyl monomer, mention is made to those commonly used, and examples thereof include styrene derivatives such as styrene, chlorostyrene, and $\alpha$-methylstyrene; vinyl esters such as vinyl acetate, vinyl

butyrate, and vinyl benzoate; vinyl ethers such as vinyl isobutyl ether, vinyl-n-butyl ether, vinyl-t-butyl ether, vinyl-n-amyl ether, vinyl isoamyl ether, vinyl-n-octadecyl ether, vinyl cyclohexyl ether, ethylene glycol monobutyl vinyl ether, and triethylene glycol monomethyl vinyl ether; (meth)acrylamides such as acrylamide, methacrylamide, N-hydroxymethyl acrylamide, N-hydroxymethyl methacrylamide, N-methoxymethyl acrylamide, N-ethoxymethyl acrylamide, and N-butoxymethyl acrylamide; allyl compounds such as triallyl isocyanurate, diallyl phthalate, diallyl isophthalate; esters of (meth)acrylic acids such as 2-ethylhexyl (meth)acrylate, lauryl (meth)acrylate, tetrahydro furfuryl (meth)acrylate, isobornyl (meth)acrylate, phenyl (meth)acrylate, phenoxyethyl (meth)acrylate; hydroxyalkyl (meth)acrylates such as hydroxyethyl (meth)acrylate, hydroxypropyl (meth)acrylate, pentaerythritol tri(meth)acrylate; alkoxyalkylene glycol mono(meth)acrylates such as methoxyethyl (meth)acrylate and ethoxyethyl (meth)acrylate; alkylene polyol poly(meth)acrylates such as ethylene glycol di(meth)acrylate, butanediol di(meth)acrylates; alkylene polyol poly(meth)acrylates, neopentyl glycol di(meth)acrylate, 1,6-hexanediol di(meth)acrylate, trimethylolpropane tri(meth)acrylate, pentaerythritol tetra(meth)acrylate, and dipentaerythritol hexa(meth)acrylate; polyoxyalkylene glycol poly(meth)acrylates such as diethylene glycol di(meth)acrylate, trietylene glycol di(meth)acrylate, ethoxylated trimethylolpropane triacrylate, and propoxylated trimethylol propane tri(meth)acrylate; poly(meth)acrylates such as hydroxypivaic acid neopentylglycol ester di(meth)acrylate; and isocyanuric type poly(meth)acrylates such as tris[(meth) acryloxyethyl]isocyanurate, and the like. These may be used alone or two or more in combination in accordance with the required characteristics.

In the case of accelerating thermosetting reaction with the epoxy resin in the curable resin composition of the present invention, or where the curable resin composition of the present invention is of an alkali-developable type, a carboxyl group-containing resin is preferably used as the curable resin. The carboxyl group-containing resin may be a carboxyl group-containing photosensitive resin having an ethylenically unsaturated group, and may or may not have an aromatic ring.

As the curable resin, two or more of thermosetting resins, photocurable resins, and carboxyl group-containing resins can be used in combination. In particular, when the epoxy resin and the carboxyl group-containing resin are used in combination, the equivalent of the epoxy group contained in the epoxy resin is preferably 2.0 or less, more preferably 1.5 or less, and further more preferably 1.0 or less per 1 equivalent of the carboxyl group contained in the carboxyl group-containing resin. This is because when the epoxy group is contained, the resin tends to discolor.

When a photocurable resin is used in the curable resin composition of the present invention, it is preferable to add a photopolymerization initiator. Examples of the photopolymerization initiator include benzoin compounds such as benzoin, benzoin methyl ether, benzoin ethyl ether, benzoin isopropyl ether, benzoin isobutyl ether, and benzyl methyl ketal and alkyl ethers thereof; acetophenones such as acetophenone, 2,2-dimethoxy-2-phenylacetophenone, 2-hydroxy-2-methyl-1-phenylpropan-1-one, diethoxyacetophenone, 2,2-diethoxy-2-phenylacetophenone, 1,1-dichloroacetophenone, 1-hydroxycyclohexyl phenyl ketone, and 2-methyl-1-[4-(methylthio)phenyl]-2-morpholino-propane-1-one; anthraquinones, such as methylanthraquinone, 2-ethylanthraquinone, 2-tert-butylanthraquinone, 1-chloroanthraquinone, and 2-amylanthraquinone; thioxanthones such as thioxanthone, 2,4-diethylthioxanthone, 2-chlorothioxanthone, 2,4-dichlorothioxanthone, 2-methylthioxanthone, and 2,4-diisopropylthioxanthone; ketals such as acetophenone dimethyl ketal and benzyl dimethyl ketal; benzophenones such as benzophenone and 4,4-bismethylaminobenzophenone, and the like. These can be used alone or two or more can be used in combination, and further can be used in combination with tertiary amines such as triethanol amine and methyl diethanol amine; and a photopolymerization initiator auxiliary such as benzoic acid derivatives such as 2-dimethylaminoethylbenzoic acid or 4-dimethyl amino ethyl benzoate.

When the curable resin composition of the present invention contains a thermosetting resin, at least one of a curing agent and a curing catalyst may be further added.

Examples of the curing agent include polyfunctional phenolic compounds, polycarboxylic acids and anhydrides thereof, aliphatic or aromatic primary or secondary amines, polyamide resins, isocyanate compounds, polymercapto compounds, and the like. Among them, use is preferably made to polyfunctional phenolic compounds, and polycarboxylic acids and acid anhydrides thereof from the viewpoint of workability and insulation.

As the polyfunctional phenol compound, use may be made to any compound having two or more phenolic hydroxyl groups in one molecule, and commonly used compounds can be used. Specific examples thereof include phenol novolac resins, cresol novolac resins, bisphenol A, allylated bisphenol A, bisphenol F, novolac resins of bisphenol A, vinylphenol copolymer resins, and the like, and especially preferred are phenol novolac resins because of their high reactivity and effect of increasing heat resistance. Such polyfunctional phenolic compounds undergo addition reaction with at least any one of the epoxy compound or the oxetane compound in the presence of a suitable curing catalyst.

Polycarboxylic acids and acid anhydrides thereof are compounds having two or more carboxyl groups in one molecule and acid anhydrides thereof, examples thereof being (meth)acrylic acid copolymers, maleic anhydride copolymers, and condensation products of dibasic acids. Examples of commercially available products include Joncryl (name of product group) manufactured by Johnson Polymer Co., Ltd., SMA resin (name of product group) manufactured by Sartomer Co., Ltd., and poly azelaic acid anhydrides manufactured by New Japan Chemical Co., Ltd.

It is satisfactory that the blending ratio of these curing agents are determined at a usually used quantitative ratio, and when a thermosetting resin is contained, it is preferably 1 to 200 parts by mass and more preferably 10 to 100

parts by mass, with respect to 100 parts by mass of the thermosetting resin in terms of solid content. In this range, a good cured state is obtained.

The curing catalyst is a compound which can be a curing catalyst in the reaction between at least any one of thermosetting resins of an epoxy compound and an oxetane compound and a curing agent, or a compound which can be a polymerization catalyst when no curing agent is used. Specific examples of the curing catalyst include tertiary amines, tertiary amine salts, quaternary onium salts, tertiary phosphines, crown ether complexes, and phosphonium ylides, and from these, one can be optionally used alone or two or more in combination.

Among the above, particularly, imidazoles such as product names of 2E4MZ, C11Z, C17Z, 2PZ; AZINE compounds of imidazoles such as product names of 2MZ-A and 2E4MZ-A; isocyanuric acid salts of imidazoles such as product names of 2MZ-OK and 2PZ-OK; imidazole hydroxymethyl such as product names of 2PHZ, 2P4MHZ (product names are all manufactured by Shikoku Chemicals Corporation); dicyandiamide and its derivatives, melamine and its derivatives; diaminomaleonitrile and its derivatives; amines such as diethylenetriamine, triethylene tetramine, tetraethylene pentamine, bis(hexamethylene)triamine, triethanolamine, diaminodiphenylmethane, and organic acid dihydrazide; 1,8-diazabicyclo[5,4,0]undecene-7 (product name: DBU, manufactured by San-Apro Ltd.); 3,9-bis(3-aminopropyl)-2,4,8,10-tetraoxaspiro[5,5]undecane (product name: ATU, manufactured by Ajinomoto Co., Inc.); and organic phosphine compounds such as triphenylphosphine, tricyclohexylphosphine, tributylphosphine, and methyldiphenylphosphine.

It is satisfactory that the blending amount of these curing catalysts is determined at a usual ratio, and when a thermosetting resin is contained, the blending amount is preferably 0.05 to 10 parts by mass and more preferably 0.1 to 7 parts by mass, with respect to 100 parts by mass of the thermosetting resin in terms of solid content. A good cured state is obtained when the amount of the curing catalyst is 0.05 parts by mass or more, and on the other hand, appropriate adhesion is obtained when the amount of the curing catalyst is 10 parts by mass or less.

The curable resin composition of the present invention may further contain a reactive diluting solvent. The reactive diluting solvent is used for increasing the cross-linking density, improving adhesion, and the like, as well as improving workability by adjusting the viscosity of the composition, and a photocurable monomer and the like can be used. As the photocurable monomer, use can be made to the above-described photo-polymerizable vinyl monomer, and the like.

The blending ratio of such reactive diluting solvent is preferably 1 to 100 parts by mass and more preferably 1 to 70 parts by mass, with respect to 100 parts by mass of the curable resin in terms of solid content. When the blending ratio is within the above range, the photocuring property is improved, and as a result, the patterns can be easily formed and the strength of the cured coating film can also be improved.

The curable resin composition of the present invention may contain a filler. As the filler, commonly used inorganic or organic fillers can be used, and particularly, use is preferably made to barium sulphate, spherical silica, neuburg siliceous earth particles, and talc. Aluminum hydroxide, magnesium hydroxide, boehmite and the like can also be used for the purpose of imparting flame retardancy. In addition, use can be made to compounds having one or more ethylenically unsaturated groups, or NANOCRYL (product name) XP 0396, XP 0596, XP 0733, XP 0746, XP 0765, XP 0768, XP 0953, XP 0954, and XP 1045 (all grade names of the product) manufactured by Hanse Chemie, and NANOPOX (product name) XP 0516, XP 0525, and XP 0314 (all grade names of the product) manufactured by Hanse Chemie, in which nanosilica is dispersed in the above-described polyfunctional epoxy resins. These may be used alone or two or more in combination. By including a filler, it is possible to increase the physical strength, etc., of the obtained cured product.

The blending amount of the filler is preferably 500 parts by mass or less, more preferably 0.1 to 300 parts by mass, and particularly preferably 0.1 to 150 parts by mass, with respect to 100 parts by mass of the curable resin, in terms of solid content. When the amount of the filler is 500 parts by mass or less, the viscosity of the curable resin composition does not become too high, the printing property becomes better, and the cured product does not easily become brittle.

The curable resin composition of the present invention may contain an organic solvent for the purpose of preparing the composition, adjusting the viscosity when applying to a substrate or a carrier film, and the like. As for the organic solvents, use can be made to commonly used organic solvents such as ketones such as methyl ethyl ketone and cyclohexanone; aromatic hydrocarbons such as toluene, xylene and tetramethylbenzene; glycol ethers such as cellosolve, methyl cellosolve, butyl cellosolve, carbitol, methyl carbitol, butyl carbitol, propylene glycol monomethyl ether, dipropylene glycol diethyl ether, diethylene glycol monomethyl ether acetate and tripropylene glycol monomethyl ether; esters such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate, and propylene carbonate; aliphatic hydrocarbons such as octane and decane; and petroleum solvents such as petroleum ether, petroleum naphtha and solvent naphtha. These organic solvents can be used alone or two or more in combination.

Further, the curable resin composition of the present invention may contain other additives commonly used in the field of electronic materials. Examples of the other additives include a thermal polymerization inhibitor, an ultraviolet absorber, a silane coupling agent, a plasticizer, a flame retardant, an antistatic agent, an antioxidant, an antibacterial / antifungal agent, a defoaming agent, a leveling agent, a filler, a thickening agent, an adhesion imparting agent, a

thixotropic imparting agent, other coloring agents, a photo-initiating assistant, a sensitizer, a curing accelerator, a mold release agent, a surface treatment agent, a dispersant, a wet dispersant, a dispersing agent, a surface modifier, a stabilizer, a fluorescent substance, and the like.

The curable resin composition of the present invention is preferably liquid at 25 °C. The term "liquid" means in a liquid state having flowability.

The curable resin composition of the present invention may be used as it is in a liquid state or used by making into a dry film. When used as a liquid, it may be in one-part or two-part or more.

The curable resin composition of the present invention is used for the forming a cured coating film, particularly a permanent coating film, and is suitably used as an insulating material. The insulating material may be used for forming a solder resist, an interlayer insulating material, a coverlay, or a solder dam, and particularly, it can be preferably used for forming a solder resist. In addition, the curable resin composition of the present invention may be used to form a protective film for a semiconductor wafer.

< Dry Film >

The dry film of the present invention is provided with a resin layer formed by applying and drying the above-described curable resin composition on a carrier film. In forming a dry film, the curable resin composition of the present invention is first diluted with the above-described organic solvent and adjusted to an appropriate viscosity, and then applied to a carrier film to a uniform thickness by, for example, a comma coater, a blade coater, a lip coater, a rod coater, a squeeze coater, a reverse coater, a transfer roll coater, a gravure coater, or a spray coater. Thereafter, by drying the coated composition at a temperature of 40 to 130 °C for 1 to 30 minutes in general, a resin layer can be formed. Generally, the coating film thickness is, without particular limitation, appropriately selected in the range of 3 to 150 μm and preferably 5 to 60 μm, in the thickness after drying the coating film.

As the carrier film, a plastic film is used, and for example, use can be made to a polyester film such as polyethylene terephthalate (PET), a polyimide film, a polyamide-imide film, a polypropylene film, a polystyrene film, and the like. Generally, the thickness of the carrier film is, without particular limitation, appropriately selected in the range of 10 to 150 μm. The range of 15 to 130 μm is more preferable.

After the resin layer comprising the curable resin composition of the present invention is formed on the carrier film, preferably a peelable cover film is further laminated on the surface of the resin layer for the purpose of preventing dust from adhering to the surface of the resin layer. As the peelable cover film, use can be made to, for example, a polyethylene film, a polytetrafluoroethylene film, a polypropylene film, a surface-treated paper, and the like. The cover film may be any film as long as it has smaller adhesive strength when peeling off than that between the resin layer and the carrier film.

In the present invention, the curable resin composition of the present invention may be coated on the cover film and dried to form a resin layer, and a carrier film may be laminated on the surface of the resin layer. That is, as the film on which the curable resin composition of the present invention is coated in the production of the dry film in the present invention, either of the carrier film or the cover film may be used.

< Cured Product >

The cured product of the present invention is obtained by curing the above-described curable resin composition. More specifically, it refers to the state where, upon placing a waste containing isopropyl alcohol on the surface of the curable resin composition which has been subjected to curing treatment and then placing a 500g weight on the waste, leaving to stand for 1 minute, the curable resin composition is not attached to the surface of the waste. Examples of the cured product include a cured coating film obtained by coating a curable resin composition to an object to be coated and curing the composition. The object to be coated is not particularly limited, and any known object to be coated on which a cured coating film is provided may be used, and example, use can be suitably made to not only an object to be coated such as a flat plate, but also for a three dimensional structure having a three dimensional structure on the coating surface. The three dimensional structure can be polyhedral and spherical. Examples of such an object to be coated include a flexible printed wiring board, a three dimensional wiring board, and the like, and in particular, it can be suitably used for a three dimensional wiring board. The three dimensional circuit board refers to a plastic molded article with an electric circuit wiring having a mechanical function and an electric function, and includes, for example, a three dimensional wiring board in which a circuit is directly formed on the three dimensional wiring board as described in Patent Documents 1 to 4. As the molding material for the three dimensional wiring board, known materials are used, and examples thereof include a mixture of an organic material using a resin and an inorganic material.

As the inorganic material, use can be suitably made to silica, alumina, a silicon nitride sintered body, a sialon sintered body, a silicon carbide sintered body, an alumina sintered body, an aluminum nitride sintered body, and the like. In addition to these materials, a material obtained by molding a metal and applying an insulating treatment to the

surface may be used.

As the organic material, a thermosetting resin and a thermoplastic resin can be preferably used. Examples of the thermosetting resin include an epoxy resin, a melamine resin, a phenol resin, a urea resin, an unsaturated polyester resin, and the like. Examples of the thermoplastic resin include polyethylene, polypropylene, polystyrene, an ABS resin, a polyvinyl chloride resin, a methyl methacrylate resin, nylon, a polyester resin, a fluorine resin, polycarbonate polyacetal, polyamide, polyphenylene ether, amorphous polyarylate, polysulfone, polyethersulfone, polyphenylene sulfide, polyetheretherketone, polyimide, polyetherimide, liquid crystal polymer, and the like.

In the three dimensional circuit board, the three dimensional board is preferably made of a resin molded article, wherein a circuit is formed on the resin molded article, and desirably, a thermoplastic resin is used which is light in weight and easy to mold, and in particular, since the three dimensional circuit board is mounted with electronic components with solder, suitable plastics are those which are called engineering plastics having excellent heat resistance, such as a fluoro resin, polycarbonate polyacetal, polyamide, polyphenylene ether, amorphous polyarylate, polysulfone, polyethersulfone, polyphenylene sulfide, polyetheretherketone, polyimide, polyetherimide, and liquid crystal polymer.

In the three dimensional circuit board, a known method can be used for forming a circuit on the three dimensional board surface, and the method may be appropriately selected according to the purpose. In particular, in the three dimensional circuit board, after a non-conductive metal complex is dispersed in a molding resin which is a material of the three dimensional board and the three dimensional board is molded using the molding resin, a laser beam is irradiated in accordance with the circuit pattern to generate a metal nuclei, and thereafter plating can be performed to form a circuit.

The non-conductive metal complex used for forming the three dimensional circuit board is not particularly limited. Examples of the central metal of the non-conductive metal complex include copper (Cu), nickel (Ni), palladium (Pd), silver (Ag), gold (Au), platinum (Pt), tin (Sn), iron (Fe), cobalt (Co), chromium (Cr), rhodium (Rh), ruthenium (Ru), and the like. Examples of the ligand of the non-conductive metal complex include β-diketones such as acetylacetone, benzoylacetone, and dibenzoylmethane; organic carbonyl compounds such as β-ketocarboxylic acid esters such as ethyl acetoacetate; organic nitrogen compounds such as organic nitrogen compounds having -N=N- bond, organic nitrogen compounds having -C=N- and -OH bonds, and organic nitrogen compounds having -N< and -OH bonds; organic sulfur compounds such as organic sulfur compounds having >C=S bond; and organic sulfur compounds having -C-SH bond; and the like.

The laser beam is not particularly limited as long as it can emit metal by irradiating against the above-described non-conductive metal complex. As the wavelength of the laser beam, for example, 248 nm, 308 nm, 355 nm, 532 nm, 1064 nm, and 10600 nm can be used.

< Printed Wiring Board >

The printed wiring board of the present invention has a cured product obtained from the curable resin composition of the present invention or a resin layer of a dry film. As a method for producing a printed wiring board of the present invention, for example, the curable resin composition of the present invention is adjusted to a viscosity suitable for the coating method using the above-described organic solvent and then coated on a base material by various methods such as dip coating, flow coating, roll coating, bar coating, screen printing, curtain coating, ink jet coating, dispensing, and the like. In particular, coating by the dispensing method is preferable. Here, the dispensing method refers to a method of formation by coating a liquid substance by means of a nozzle. After the coating, full curing is conducted by heat curing at 60 to 220 °C for 20 to 120 minutes using a hot-air circulation drying furnace to form a cured coating film having excellent properties such as adhesion and hardness.

In the case of coating for multiple times, full curing is conducted by, for example, heat curing at 60 to 150 °C for 5 to 60 minutes using a hot air circulation drying furnace in the first coating, and in the second coating full curing is conducted by, for example, heat curing at 60 to 220 °C for 20 to 120 minutes using a hot air circulation drying furnace. The curable resin composition for the first coating and the curable resin composition for the second coating may have different compositions; however the composition is preferably the same. Here, the same composition means that the kind of component of the resin and the blending ratios thereof are the same.

On the other hand, in the case of a dry film, full curing is conducted under the above-described conditions upon bonding the resin layer to the base material so that the resin layer is in contact with the base material using a laminator etc., and subsequently peeling off the carrier film to form a resin layer on the base material. The full curing carried out after coating the curable resin composition of the present invention can be carried out using a hot air circulation drying furnace, an IR furnace, a hot plate, a convection oven, and the like (a method in which hot air in the drying machine is brought into counter-flow contact using a heat source of air heating method by means of steam and a method in which spraying is done against a support by a nozzle).

When the curable resin composition contains not only the thermosetting resin but also a photocurable component such as a photocurable resin, a pattern of a cured product may be formed by forming a resin layer on the base material, selectively exposing the layer to active energy rays through a photomask onto which a predetermined pattern is formed,

and developing the unexposed portion with, for example, an aqueous dilute alkali solution such as 0.3 to 3 mass% sodium carbonate aqueous solution. Note that, when the curable resin composition of the present invention contains a photobase generator, heating is preferably done after exposure and before development, and the heating condition after exposure and before development is heating at, for example, 60 to 150 °C for 1 to 60 minutes.

The exposure machine used for exposure by active energy rays may be any device which is mounted with a high-pressure mercury lamp, an extra-high-pressure mercury lamp, a metal halide lamp, a mercury short arc lamp, and the like, and which irradiates ultraviolet rays in a range of 350 to 450 nm, and further, use can be made to a direct drawing device (for example, a laser direct imaging device for directly drawing an image by laser using CAD data from the computer). The lamp light source or laser light source of the direct drawing device may be those having a maximum wavelength in the range of 350 to 450 nm. The amount of exposure for image formation varies depending on the film thickness and the like, and generally may be in the range of 10 to 1000 $mJ/cm^2$ and preferably in the range of 20 to 800 $mJ/cm^2$.

As the developing method, use can be made to a dipping method, a shower method, a spray method, a brush method, and the like, and as the developing solution, use can be made to an alkali aqueous solution of potassium hydroxide, sodium hydroxide, sodium carbonate, potassium carbonate, sodium phosphate, sodium silicate, ammonia, amines, and the like.

EXAMPLE

The present invention will be described in further details with reference to the following examples; however the present invention is not limited to these examples. Note that, in the following, "part" and "%" are all on a mass basis unless otherwise specified.

< Synthesis of Photocurable Resin 1 >

380 parts of a bisphenol F type epoxy resin (epoxy equivalent: 950 g/eq, softening point: 85 °C) in which X in general formula (II) is $CH_2$ and the average degree of polymerization n is 6.2 and 925 parts of epichlorohydrin were dissolved in 462. 5 parts of dimethylsulfoxide, and subsequently, 60.9 parts of 98.5% NaOH were added under stirring at 70 °C over 100 minutes. After the addition, further reaction was carried out at 70 °C for 3 hours. After the reaction was completed, 250 parts of water was added and the mixture was washed with water. After separating the oil and water, most of dimethylsulfoxide and the excessive unreacted epichlorohydrin were recovered by distillation under reduced pressure, and the reaction product comprising the residual byproduct of salt and dimethylsulfoxide was dissolved in 750 parts of methyl isobutyl ketone, and further 10 parts of 30% NaOH was added, and reaction was condcuted at 70 °C for 1 hour. After the reaction was completed, the reaction mixture was washed twice with 200 parts of water. After separating the oil and water, methyl isobutyl ketone was recovered by distillation to obtain an epoxy resin (a) having an epoxy equivalent of 310 g/eq and a softening point of 69 °C. As calculated from the epoxy equivalent, the obtained epoxy resin (a) was one in which about 5 of 6.2 alcoholic hydroxyl groups in the above-described starting bisphenol F type epoxy resin was epoxidized. 310 parts of this epoxy resin (a) and 282 parts of carbitol acetate were charged into a flask, heated to 90 °C and stirred to dissolve. The resulting solution was once cooled to 60 °C, and to this were added 72 parts (1 mol) of acrylic acid, 0.5 part of methylhydroquinone, and 2 parts of triphenylphosphine, and the mixture was heated to 100 °C for reaction for about 60 hours to give a reaction product having an acid value of 0.2 mg KOH/g. To this was added 140 parts (0.92 mol) of tetrahydrophthalic anhydride, and the mixture was heated to 90 °C for reaction to obtain a resin solution of Photocurable resin 1. The obtained resin solution had a solid concentration of 65.0% and a solid acid value (mg KOH/g) of 100.

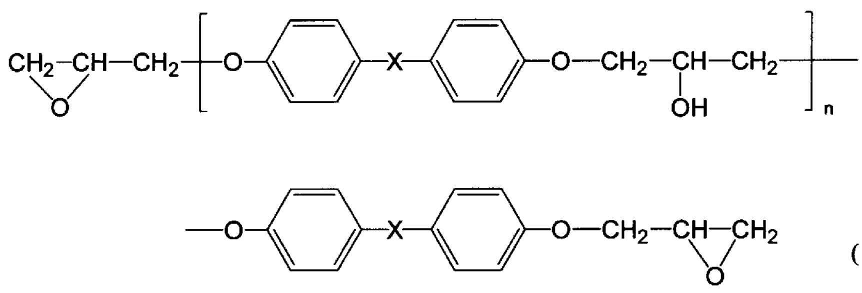

(II)

X represents $CH_2$ or $C (CH_3)_2$ and n represents 1 to 12.

< Preparation of Curable Resin Composition >

Each of the components shown in the following Table 1 were mixed in the proportions (parts by mass) shown in the Table, pre-mixed by an agitator, and dispersed by a 3-roll mill to prepare each of the curable resin compositions of Examples 1 to 3 and Comparative Example 1. The numerical values shown in Table 1 mean the solid content (parts by mass).

*1 to *15 in Table 1 represent the following components.

*1: N-695 (cresol-novolak type epoxy) manufactured by DIC Corporation
*2: EHPE3150 manufactured by DAICEL CORPORATION (alicyclic epoxy resin)
*3: Epolead PB3600 (epoxidized polybutadiene) manufactured by DAICEL CORPORATION
*4: jER630 (polyfunctional epoxy resin) manufactured by Mitsubishi Chemical Corporation
*5: jER1009 (bisphenol A type epoxy resin) manufactured by Mitsubishi Chemical Corporation
*6: HF-1 (phenol resin) manufactured by Meiwa Plastic Industries, Ltd.
*7: BPE-900 (ethoxylated bisphenol A dimethacrylate) manufactured by Shin-Nakamura Chemical Co., Ltd.
*8: DICY (dicyandiamide) manufactured by Mitsubishi Chemical Corporation
*9: 2PHZ (imidazole hydroxymethyl) manufactured by Shikoku Chemicals Corporation
*10: B-30 (barium sulphate) manufactured by Sakai Chemical Industry Co.,Ltd.
*11 : LMS-200 (Talc) manufactured by Fuji Talc Industrial Co., Ltd.
*12: R974 (silica) manufactured by Nippon Aerosil Co., Ltd.
*13: KS-66 (silicone defoaming agent) manufactured by Shin-Etsu Chemical Co., Ltd.
*14: SH203 (alkyl-modified silicone) manufactured by Toray Dow Corning Co., Ltd.
*15: Flowlen AC - 1190 (acrylic defoaming agent) manufactured by Kyoeisha Chemical Co., Ltd.

< Measurement of Shear Strength >

[Measurement of Shear Strength A]

Onto one face of a copper clad laminate ESPANEX MB (manufactured by Nippon Steel Chemical & Materials Co., Ltd.) in which a copper film is laminated on both sides of a polyimide base material, having a length of 7.5 cm, a width of 2 cm and a thickness of 25 $\mu$m, which has been buffed and subsequently washed with water and dried, was coated with each of the curable resin compositions by screen printing, and drying was conducted at 80 °C for 10 minutes. The copper clad laminate with a surface onto which a dry coating film of a curable resin composition was formed was cut into strips of 5 cm in length and 1 cm in width, and this was used as Sample 1.

Next, a FR-4 etched-out material having a length of 7.5 cm, a width of 2 cm, and a thickness of 1.6 mm, which has been buffed and subsequently washed with water and dried was prepared as Sample 2. A dry coating film face of the curable resin composition of the above-described Sample 1 was attached to one face of this Sample 2. At this time, they were attached together so that the attaching area was 5 mm in length and 10 mm in width. Samples 1 and 2 were attached together and subsequently temporarily fixed for 1 minute under vacuum using a vacuum laminator set to 80 °C, and the dry coating film of Sample 1 was fully cured by heating and curing under Curing Condition I as shown in Table 1 to form a cured coating film $\alpha$. Subsequently, only a portion in 3 mm in length was detached from the end portion of the attached face between Samples 1 and 2, and as shown in FIG. 1, only the sample in which the attaching area was 2 mm in length and 10 mm in width was used as a sample for measuring shear strength A.

With respect to each of the above-described samples for measurement, shear load (N) was measured at room temperature using a tensile testing machine (Autograph AG-X, manufactured by Shimadzu Corporation) at a tensile speed of 10 mm/min. A value obtained by dividing the obtained shear load by the attached area (2 mm $\times$ 10 mm) was defined as shear strength A.

[Measurement of Shear Strength B]

A FR-4 copper clad laminate MCL-E-67 (Nippon Steel Chemical & Materials Co., Ltd.) having a length of 7.5 cm, a width of 2 cm, and a thickness of 1.6 mm, which has been buffed and subsequently washed with water and dried was prepared as Sample 2'. To one face of this Sample 2' was attached a dry coating film face of Sample 1 as described in [Measurement of Shear Strength A] above. At this time, they were attached together so that the attaching area was 5 mm in length and 10 mm in width. Samples 1 and 2' were attached together and subsequently temporarily fixed for 1

minute under vacuum using a vacuum laminator set to 80 °C, and by conducting curing treatment under Curing Condition I as shown in Table 1, a cured coating film α was formed.

Subsequently, only a portion in 3 mm in length was detached from the end portion of the attached face between Samples 1 and 2', and as shown in FIG. 1, the sample in which the attaching area was 2 mm in length and 10 mm in width was used as a sample for measuring shear strength B. The sample for measuring shear strength B was used to measure shear strength B in the same manner as the measurement of shear strength A.

[Measurement of Shear Strength C]

Onto one face of a FR-4 etched out material having a length of 7.5 cm, a width of 2 cm, and a thickness of 1.6 mm, which has been buffed and subsequently washed with water and dried, was coated with the curable resin composition by screen printing, and a cured coating film β which was finally cured by heat curing under Curing Condition II as shown in Table 1 was prepared as Sample 2".

To the surface of the cured coating film β of Sample 2" was attached a dry coating film face of Sample 1 as described in [Measurement of Shear Strength A] above. At this time, they were attached together so that the attaching area was 5 mm in length and 10 mm in width. Samples 1 and 2" were attached together and subsequently temporarily fixed for 1 minute under vacuum using a vacuum laminator set to 80 °C, and by conducting curing treatment under Curing Condition I as shown in Table 1, a cured coating film α was formed on the surface of the cured coating film β.

Subsequently, only a portion in 3 mm in length was detached from the end portion of the attached face between Samples 1 and 2", and as shown in FIG. 1, a sample in which the attaching area was 2 mm in length and 10 mm in width was used as the sample for measuring shear strength C. The sample for measuring shear strength C was used to measure shear strength C in the same manner as the measurement of shear strength A.

< Preparation of Test Board for Evaluation of Characteristics of Insulating Portion and Conductive Portion of Base Material >

The curable resin compositions of Examples 1 to 3 and Comparative Example 1 were coated on one face of FR-4 etched out materials having a length of 7.5 cm, a width of 2 cm, and a thickness of 1.6 mm, which have been buffed and subsequently washed with water and dried and of FR-4 copper clad laminates MCL-E-67 (Hitachi Chemical Co., Ltd.) having a length of 7.5 cm, a width of 2 cm, and a thickness of 1.6 mm, which have been buffed and subsequently washed with water and dried, by screen printing.

Next, in Examples 1 and 2 and Comparative Example 1, cured coating films α were formed by performing curing treatment under curing condition (1) as described in Table 1, and as a result, test boards for evaluation of characteristics were obtained. With respect to Example 3, drying was done at 80 °C for 10 minutes and then left to cool to room temperature.

The boards were subjected to solid exposure using an exposure device equipped with a high-pressure mercury lamp (short arc lamp). The exposure amount was determined as one which indicated step 7 when exposure was performed using a step tablet (Kodak No. 2). Thereafter, development was done for 60 seconds under the condition of 1 wt% $Na_2CO_3$ aqueous solution of 30 °C sprayed at a spray pressure of 2 kg/cm$^2$.

Subsequently, curing treatment was performed under Curing Condition I as described in Table 1 and a cured coating film α was formed by irradiating ultraviolet rays under the condition in which an integrated exposure amount is 1000 mJ/cm$^2$ in a UV conveyor furnace, and as a result, test substrates for evaluation of characteristics were obtained. The thickness of the cured coating films after curing was 25 μm. The obtained test boards were evaluated for adhesion.

< Preparation of Test Board for Evaluation of Characteristics of Portion where Curable Resin Composition Overlaps >

The curable resin compositions of Examples 1 to 3 and Comparative Example 1 were coated onto one face of FR-4 etched out materials having a length of 7.5 cm, a width of 2 cm, and a thickness of 1.6 mm, which have been buffed and subsequently washed with water, and dried, by screen printing, and by conducting full curing under Curing Condition II as described in Table 1, cured coating films β were obtained. The thickness of the cured coating films β after curing at this time was 25 μm. Next, the curable resin compositions of Examples 1 to 3 and Comparative Example 1 were coated onto the surface of the cured coating films β of the curable resin composition by screen printing. Next, in Examples 1 and 2 and Comparative Example 1, by performing curing treatment under Curing Condition I described in Table 1, cured films α were formed on the surface of the cured films β and as a result, test boards for evaluation of characteristics were obtained. In Example 3, drying was done at 80 °C for 10 minutes and left to cool to room temperature.

These boards were subjected to solid exposure using an exposure device equipped with a high-pressure mercury lamp (short arc lamp). The exposure amount was determined as one which indicated step 7 when exposure was performed using a step tablet (Kodak No. 2). Thereafter, development was done for 60 seconds under the condition

of 1 wt% $Na_2CO_3$ aqueous solution of 30 °C sprayed at a spray pressure of 2 $kg/cm^2$.

Subsequently, curing treatment was carried out under Curing Condition I as described in Table 1, and by carrying out ultraviolet irradiation under the condition in which an integrated exposure amount is 1000 $mJ/cm^2$ in a UV conveyor furnace, cured coating films $\alpha$ were formed on the surface of the cured coating films $\beta$, and as a result, test boards for evaluation of characteristics were obtained. In this case, the film thickness of the cured coating films $\alpha$ and the cured coating films $\beta$ after curing were 50 $\mu$m. The obtained test boards were subjected to adhesion evaluation and crack evaluation in order to evaluate cracks and peeling in the portion where the curable resin overlaps.

< Evaluation of Adhesiveness >

In accordance with the test method of JIS D-0202, 100 cross-cuts were made in a grid pattern on the cured coating film of the test piece, and then the state of peeling after the peeling test with sellotape was visually determined.
○: No peeling seen
X : Peeling seen

The evaluation results are shown in Table 1 below.

< Evaluation of Cracks>

The test boards obtained by the above-described method for preparing a test board for evaluation of characteristics were subjected to 1000 cycles treatment at -65 °C and 150 °C, each for 30 minutes, gas phase, and 2 zones, and then evaluation was done by judging the presence or absence of cracks in the cured coating film by an optical microscope.
○: No crack was generated.
X: Crack(s) generated

The evaluation results are shown in Table 1 below.

[Table 1]

| Composition (parts by mass) | | Example 1 | Example 2 | Example 3 | Comparative Example 1 |
|---|---|---|---|---|---|
| Thermo-setting resin | N-695*1 | 50 | 30 | - | - |
| | EHPE3150*2 | - | - | 30 | - |
| | EpoleadPB3600*3 | - | 20 | - | - |
| | jER630*4 | - | - | - | 50 |
| | jER1009*5 | - | - | - | 5 |
| | HF-1*6 | - | 10 | - | - |
| Photocurable resin | Photocurable resin 1 | - | - | 100※ | - |
| | BPE-900*7 | - | - | 10 | - |
| Curing agent /Curing catalyst | DICY*8 | 0.5 | - | 0.5 | - |
| | 2-methyl imidazole | 1 | - | - | 1 |
| | 2-PHZ*9 | - | 0.5 | - | - |
| | melamine | - | - | 1 | - |
| Filler | B-30*10 | 30 | 100 | - | 50 |
| | LMS-200*11 | 30 | 5 | - | |
| | R974*12 | 20 | - | - | 3 |
| Solvent | Diethylenglycol monoethyl ether acetate | 5 | 25 | 25 | 5 |
| | Propylene glycol monomethylether | 40 | - | - | - |

(continued)

| Composition (parts by mass) | | | Example 1 | Example 2 | Example 3 | Comparative Example 1 |
|---|---|---|---|---|---|---|
| Defoaming agent | KS-66*13 | | 1 | 1.5 | 1 | 0.5 |
| | SH203*14 | | - | - | 0.3 | 0.5 |
| | Flowlen AC1190*15 | | - | 3 | 3 | 0.5 |
| Curing condition | Curing Condition I | | 140°C, 30 min | 150°C, 30 min | 150°C, 60 min | 150°C, 30 min |
| | Curing Condition II | | 140°C, 10 min | 150°C, 10 min | 150°C, 30 min | 150°C, 10 min |
| Shear strength (MPa) | | A | 12.3 | 10.5 | 5.0 | 6.0 |
| | | B | 11.0 | 11.2 | 6.2 | 5.9 |
| | | C | 9.3 | 8.5 | 5.6 | 0.6 |
| Evaluation of properties against insulating part and conductive part of base material | | Adhesiveness | ○ | ○ | ○ | ○ |
| Evaluation of properties on portion where curable resin composition overlaps | | Adhesiveness | ○ | ○ | ○ | × |
| | | Cracks | ○ | ○ | ○ | × |

Curing Condition I in Table 1 means:

(i) full curing condition by heat curing in forming a cured coating film $\alpha$ after attaching two samples and temporarily fixing the same in the preparation of samples for measuring shear strengths A, B, and C;
(ii) full curing condition by heat curing after second coating when the curable resin composition is coated for multiple times in the preparation of the test board for evaluation of characteristics; or
(iii) full curing condition by heat curing after coating the curable resin composition when said curable resin composition is coated only once in the preparation of the test board for evaluation of characteristics.

Curing Condition II in Table 1 means:

(i) full curing condition by heat curing when forming a cured coating film $\beta$ in the preparation of the sample for measuring shear strength C; or
(ii) full curing condition by heat curing after first coating when the curable resin composition is coated for multiple times in the preparation of the test board for evaluation of characteristics.

As is apparent from the evaluation results in Table 1, in the curable resin compositions in which the values of the respective shear strengths A, B, and C are all within the range of 1 MPa to 15 MPa and the values of shear strengths A and B are 0.5 times or more and 5 times or less than the value of shear strength C, adhesion is excellent, and cracks are not generated in the cured coating film, even when a cured coating film was formed by conducting multiple coating on the surface of the circuit board having an insulating portion and a conductive portion, and therefore, it is understood that cracks and peeling are not generated in the portion where the curable resin composition overlaps.

## Claims

**1.** A curable resin composition comprising a curable resin, **characterized in that**:

when a cured coating film $\alpha$ comprising a cured product of the curable resin composition is formed on the surface of an insulating portion of a base material, the shear strength between the insulating portion and the cured coating film $\alpha$ is referred to as A (MPa);
when a cured coating film $\alpha$ comprising a cured product of the curable resin composition is formed on the surface

of a conductive portion of the base material, the shear strength between the conductive portion and the cured coating film $\alpha$ is referred to as B (MPa); and
when a cured coating film $\alpha$ comprising a cured product of the curable resin composition is formed on the surface of a cured coating film $\beta$ comprising the cured product of the curable resin composition, the shear strength between the cured coating film $\alpha$ and the cured coating film $\beta$ is referred to as C (MPa); then
A, B and C are all 1 MPa or more and 15 MPa or less; and
A and B are 0.5 times or more and 5 times or less than C.

**2.** The curable resin composition according to claim 1, used for forming a cured coating film on the surface of a three dimensional structure.

**3.** The curable resin composition according to claim 1 or 2, wherein the curable resin is a thermosetting resin.

**4.** The curable resin composition according to any one of claims 1 to 3, used as an insulating material.

**5.** A dry film comprising a resin layer formed by coating and drying the curable resin composition according to any one of claims 1 to 4 onto a film.

**6.** A cured product of the curable resin composition according to any one of claims 1 to 4 or the dry film of claim 5.

**7.** A printed wiring board having the cured product according to claim 6.

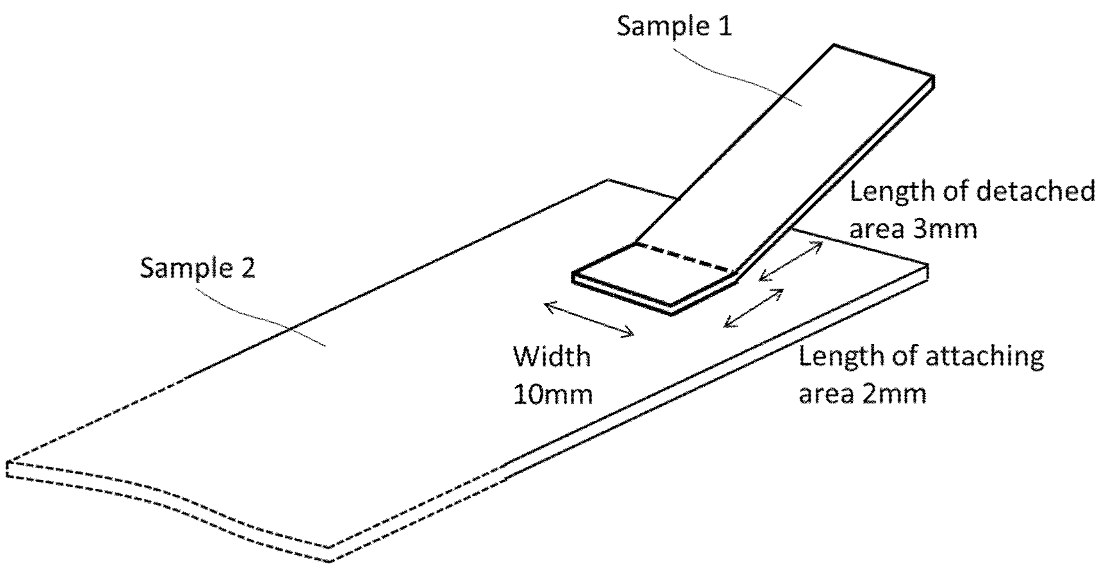
Sample 1
Length of detached area 3mm
Sample 2
Width 10mm
Length of attaching area 2mm

FIG.1

## INTERNATIONAL SEARCH REPORT

International application No.
PCT/JP2019/000833

A. CLASSIFICATION OF SUBJECT MATTER
Int. Cl. H05K3/28(2006.01)i, B32B15/08(2006.01)i, B32B27/00(2006.01)i, C08J5/12(2006.01)i, C09D201/00(2006.01)i, G03F7/004(2006.01)i, H05K1/02(2006.01)i

According to International Patent Classification (IPC) or to both national classification and IPC

B. FIELDS SEARCHED

Minimum documentation searched (classification system followed by classification symbols)
Int. Cl. H05K3/28, B32B15/08, B32B27/00, C08J5/12, C09D201/00, G03F7/004, H05K1/02

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2015-104913 A (ARISAWA MFG. CO., LTD.) 08 June 2015, entire text, all drawings (Family: none) | 1-7 |
| A | JP 2008-060270 A (FUJITSU LTD.) 13 March 2008, entire text, all drawings (Family: none) | 1-7 |
| A | JP 2011-068713 A (NAMICS CORP.) 07 April 2011, entire text, all drawings (Family: none) | 1-7 |
| A | JP 2008-248141 A (NIPPON STEEL CHEMICAL CO., LTD.) 16 October 2008, entire text, all drawings (Family: none) | 1-7 |

☐ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 29.03.2019 | 09.04.2019 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S63234603 B
- JP 2008053465 A
- JP 2001015874 A
- JP 2004534408 A